# EUROPEAN PATENT SPECIFICATION

(11) **EP 0 286 881 B1**
(45) Date of publication and mention of the grant of the patent: **05.01.1994**
(21) Application number: 88104692.4
(22) Date of filing: 24.03.1988
(51) Int. Cl.: H03K 17/97, H03K 3/45, H03M 1/22

(54) **Pulse generator with shielded wiegand wire**
Impulsgenerator mit abgeschirmtem Wieganddraht
Générateur d'impulsions utilisant un fil de Wiegand protégé

(30) Priority: 14.04.1987 US 38010; 14.07.1987 US 72916
(43) Date of publication of application: 19.10.1988
(73) Proprietor: ECHLIN INC., Branford, CT 06405 (US)
(72) Inventor: Opie, John E., Stony Creek Connecticut 06405 (US)
(74) Representative: Berkenfeld, Helmut, Dipl.-Ing.

(56) References cited:
- DE-A- 2 817 169
- DE-A- 2 826 609
- DE-A- 2 853 811
- US-A- 3 105 965
- US-A- 3 780 313
- US-A- 4 247 601
- US-A- 4 309 628
- US-A- 4 484 090
- ELECTRONICS, July 10, 1975, pages 100-105

## Description

### Background of the Invention

This invention relates in general to a pulser for generating a pulse by switching the state of a magnetic device that has come to be known as a Wiegand wire and, more particularly, to a mechanism and method for controlling the magnetic field to which a Wiegand wire module is subjected so as to provide an improved output pulse.

The magnetic device employing the pulser of this invention is of the type disclosed in U.S. Patent No. 4,247,601 issued January 27, 1981. This magnetic device is a ferro-magnetic wire segment which has been treated to provide core and shell portions with divergent magnetic properties. The wire is now known in the art as a Wiegand wire.

The Wiegand wire essentially has two states. In one of these states, the magnetization of the core and shell are in opposite directions and this state may conveniently be called a reverse state. In the other state, the magnetization of the core and shell are in the same direction and this state may conveniently be called the confluent state. When the magnetic field to which the wire is subjected passes a threshold in one direction or the other, the wire switches state. The switch in state is extremely rapid so that the rate of change of flux through a pick-up coil wrapped around the wire is great. As a consequence the output from the pick-up coil is very substantial, in some cases being as high as eight volts into an open circuit on a repeatable basis. The wire and pick-up coil is referred to as a module.

The characteristics of a pulse generator which are desirable include simplicity, low cost, versatility, repeatability, reliability and high output pulse. There are inevitably certain trade-offs in enhancing certain of these characteristics at the expense of other characteristics. However, it is desirable to provide an optimum combination of these characteristics with whatever enhancement of the characteristics may be achieved in an improved design and such is the general purpose of this invention.

U.S. Patent No. 4,309,628 issued January 5, 1982, discloses an arrangement in which a Wiegand wire module is triggered by a shunt element. Disclosed therein are various shunt structures which might be employed to provide a shunt trigger for the Wiegand wire. Disclosed in that patent are (1) a non-ferrous disk with low reluctance elements deployed on the face of the disk, (2) a rotating non-ferrous drum with low-reluctance elements deployed around the rim of the drum, (3) a ferrous rotating disk with a series of ferrous lobes that protrude radially from the rim of the disk, and (4) a ferrous rotating disk with a plurality of cut-out zones on the face of the disk.

U.S. Patent No. 4,484,090 entitled Pulsed Generator With Shaped Magnetic Field issued November 20, 1984 discusses the problem that arises because of the demagnetization field at the ends of the Wiegand wire. That patent discloses a pulser in which the excitation field is shaped so as to minimize the axial field at the ends of the wire thereby minimizing the effects of the demagnetization field at the end of the wire. This shaped field design provides an improved pulser in that the more rapid switch in flux when the demagnetization field is minimized provides a larger output pulse in the pick-up coil than is the case when the field at the ends of the wire is significant. The increased pulse magnitude provided by the shaped field design disclosed in this patent serves to enhance the utility of the pulser. However, it has been found that the improvement provided is not as consistent and repeatable as is desirable in operating equipment. In particular, the effects of ambient fields and, most particularly, changing ambient fields results in a loss of repeatability and consistent pulse output magnitude.

A further full description of the structure and the operation of a Wiegand wire is provided by Mr. Philip E. Wigen in Electronics, July 10, 1975, pages 100 to 105. As it is now well-known, John Wiegand discovered that by properly work-hardening a magnetic wire, it is possible, along the exterior "shell" of the wire, to produce a coercive force significantly greater than the coercive force in the wire's core. By virtue of this magnetic differential, and depending on certain external conditions, the direction of magnetization in the core of the wire can be the same or opposite to that in the shell. And switching from one state to the other is easily and repeatably induced at well-defined magnetic-field levels.

Proceeding from this state of the art, it is the underlying objective of the invention to provide a pulser device in which the enhanced output pulse obtained by a shaped magnetic field is provided in a repeatable and consistent fashion. It is also desired that the pulser device will be tolerant to variations in the geometric configuration and strength of the excitation field and yet provide a repeatable and consistent output pulse. The invention also aims at obtaining a method of providing a pulse train.

According to the present invention, the solution to this objective is obtained by a pulser device which comprises the following features:
a pulser unit having a Wiegand wire module and soft ferro-magnetic guide means,
said Wiegand wire module including a Wiegand wire segment and a pick-up coil wound on said segment, said module having first and second end portions,
said ferro-magnetic guide means surrounding at least first and second ends of said module, said guide means including a high reluctance zone adjacent to the center of said module and a lower reluctance zone adjacent to the ends of said module,
said guide means being shaped to collect and guide flux that is incident on the pulser unit to said high reluctance zone causing leakage flux to be coupled to the center portion of said Wiegand wire,
said guide means including first and second guide elements spaced from one another to provide said high reluctance zone.

Appropriate further developments of this device and the method of providing a pulse train form the subject matter of subclaims.

### Brief Description

The pulse generating unit of this invention involves a Wiegand wire module mounted within two soft ferro-magnetic guide elements. These two guide elements perform two major functions. The first function is to magnetically shield the two ends of the Wiegand wire module so as to substantially eliminate the known end demagnetization effect which reduces the output pulse when the Wiegand wire switches state. This is achieved by having small cylindrical cavity elements within each of the two shunts into which cavity elements the ends of the Wiegand wire module are mounted. The second major function is to collect, conduct and guide incident flux from an adjacent drive magnet in such a fashion as to direct the flux across an air gap between the two shunt elements. The result is to assure that there will be enough leakage flux to drive the Wiegand wire and thus cause it to change state. The change of state of the Wiegand wire provides a rapid change in the flux coupled through the pick-up coil on the module thereby producing a significant and usable output pulse.

In a first embodiment, this pulser unit when combined with a movable magnet that upon motion is coupled and uncoupled to the Wiegand wire, provides a device that can be used as a proximity measuring device, a speed measuring device or a position measuring device.

In a second embodiment, magnets mounted onto the guide elements constitute flux generating units for first and second magnetic circuits, respectively. The polarity of the magnets and their positioning is such that the flux from the two magnetic circuits are substantially equal in amplitude and opposite in direction at an air gap between the two guide elements. The result is that in the normal state, the Wiegand wire is subject to substantially no incident flux.

A low reluctance shunt brought adjacent to the magnets in the first magnetic circuit substantially reduces the reluctance in that circuit thereby increasing the flux in that circuit. The result is an unbalance of flux at an air gap between the two guide elements. As a consequence, the unbalanced leakage flux is enough to drive the Wiegand wire and cause it to change state. The change in state of the Wiegand wire provides rapid change in the flux coupled through the pick-up coil on the module thereby producing a significant usable output pulse.

A similar result occurs when the low reluctance shunt is brought adjacent to the magnets that generate the second magnetic circuit.

### Brief Description of the Figures

FIG. 1 is a cut-away perspective view of a first embodiment of this invention showing the two ferro-magnetic shunts 12 within which is contained the module 11 that constitutes the Wiegand wire and pick-up coil. FIGS. 1A and 1B show details of the FIG. 1 device.

FIG. 2 is a longitudinal sectional view of the module 11 showing the elliptical pick-up coil 18.

FIGS. 3A and 3B are sectional and end views of one of the shunts 12.

FIG. 4 is a schematic representation of a speed sensor device using the FIG. 1 pulser 10 in which output pulses are obtained by an excitation field provided by magnets 32 on a rotating disc 30.

FIG. 4A illustrates the output pulse train obtained from the FIG. 4 device.

FIG. 5A illustrates a hysteresis curve of a prior art pulser where the Wiegand wire is subject to a long excitation field applied as a symmetric drive. FIG. 5B shows the contrasting hysteresis curve typical of the FIG. 1 pulser wherein the Wiegand wire is subject to a short excitation field applied as a symmetric drive.

FIG. 6A illustrates a hysteresis curve of a prior art pulser where the Wiegand wire is subject to a long excitation field applied as an asymmetric drive. FIG. 6B shows the contrasting hysteresis curve typical of the FIG. 1 pulser wherein the Wiegand wire is subject to a short excitation field applied as an asymmetric drive.

FIG. 7 is a cutaway perspective view of a second embodiment of this invention showing the two ferro-magnetic guides 12 within which is contained the module 11 comprising the Wiegand wire and pick-up coil. One magnet M1 is shown and only a portion of the other three magnets M2, M3 and M4 is shown.

FIG. 8 is a cross-sectional schematic of the FIG. 7 pulser. The plane of FIG. 8 includes the axis of the Wiegand wire and is perpendicular to the face of the magnetic guides 12 on which the magnets are mounted. FIG. 8 only shows two magnets M3 and M4 of the four magnets employed. FIG. 8 schematically indicates the path of the lines of flux in the first magnetic circuit which incorporates the magnets M3 and M4 as the energizing elements.

FIG. 9 is a simplified perspective of the FIG. 7 and FIG. 8 device showing the four magnets employed. Associated with FIG. 9 is an equivalent electrical circuit representing the two magnetic circuits involved.

FIG. 10 illustrates the FIG. 9 device in which the ferro-magnetic shunt element 30 has been brought adjacent to the magnets M1 and M2 that constitute the energizing elements of the first magnetic circuit. Associated with FIG. 10 is an equivalent electrical circuit representing the magnetic circuit state created by the positioning of the shunt element 30 as shown.

FIG. 11 is a view similar to that of FIG. 10 with the shunt element 40 placed adjacent to the magnets M3 and M4 which constitute the energizing elements for the second magnet circuit. Associated with FIG. 11 is an equivalent electrical circuit representing the magnetic circuit state created by positioning the shunt element 40 as shown.

FIG. 12 is a perspective of a further embodiment of the invention.

### Description of the Preferred Embodiments

### The Moving Magnet Embodiment

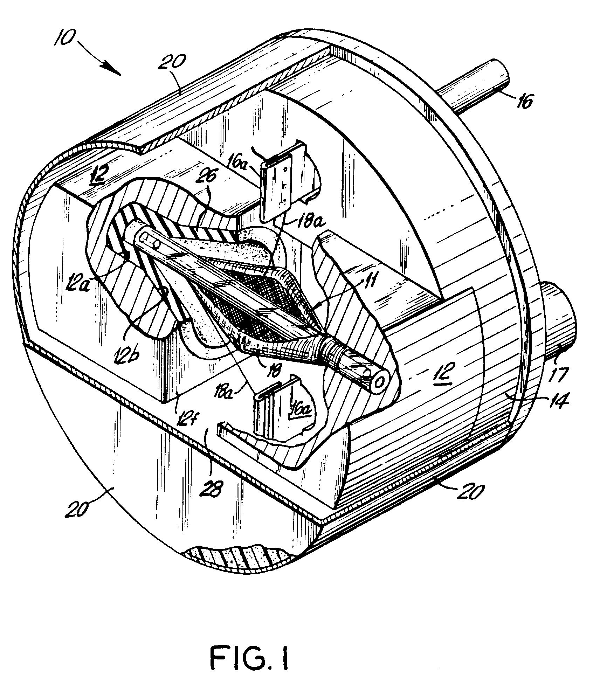

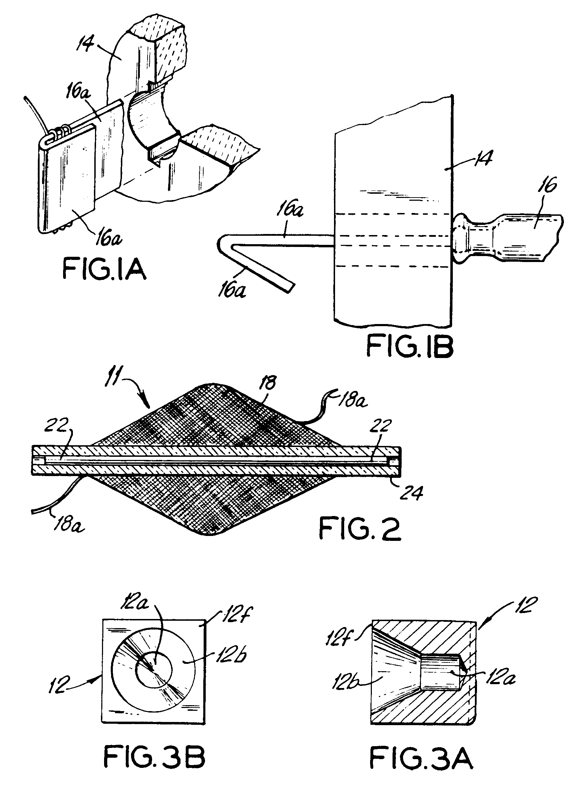

As shown in FIG. 1, the pulser 10 includes a Wiegand wire module 11 mounted within a cavity that is defined by two magnetically soft ferro-magnetic guide elements 12. The module 11 and both guides 12 are held on a molded plastic base 14. Two terminals 16 (only one is shown) extend through the base 14 and are connected to the ends of the pick-up coil 18 that is a part of the module 11. A stainless steel cap 20 fits over the guide elements 12 and the periphery of the base 14. The base 14 includes a short positioning lug 17 to aid in orienting the pulser when assembling it onto other equipment.

The module 11 consists of (a) a Wiegand wire element 22 held within a glass tube 24 and (b) the pick-up coil 18 wound around the central portion of the glass tube 24. The coil 18 is coupled to the changing magnetic field produced by the switch in the magnetic state of the Wiegand wire 22. The ends of the glass tube 24, and thus the ends of the Wiegand wire 22, are mounted in shallow cylindrical recesses 12a of the guide elements 12. Rubber end caps 26 are positioned over the ends of glass tube 24 and fit within the cylindrical recesses 12a so as to provide a firm, resilient and safe mount for the glass tube 24. These end caps 26 extend inboard along the conical walls of the cavity in the guide 12. Only one end cap 26 is shown. The break away view eliminates the other cap.

The cavity within each guide element 12 is defined by the cylindrical recess 12a at the outboard ends of each cavity and by the truncated conical zone 12b which is inboard from the cylindrical recess 12a. The conical cavity zone 12b has its smallest diameter at the cylindrical recess 12a and increases in diameter to the central face 12f of the guide element 12. The central faces 12f of the two guide elements 12 are spaced from one another thereby establishing a small gap 28 between the two guide elements 12.

Lead wires 18a from the pick-up coil 18 are wrapped around a folded over terminal end 16a which is crimped and welded to hold the lead wires 18a in place and assure good electrical contact. The terminal 16 is a cylindrical terminal that extends through the plastic base 14 and has the flat end 16a. Accordingly, an output pulse generated in the pick-up coil 18 will be transmitted to the terminal 16.

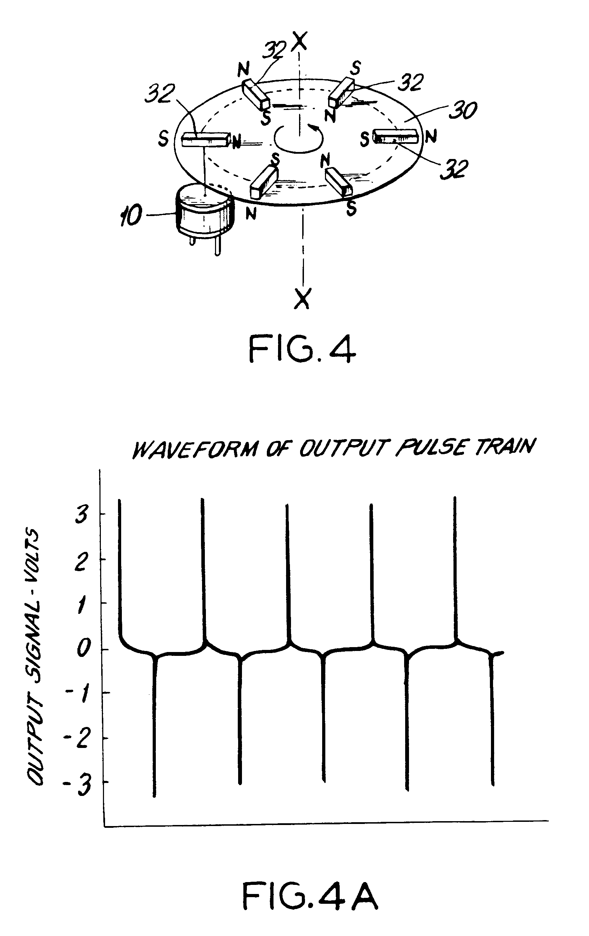

As shown in FIG. 4, the pulser 10 may be magnetically driven by a set of magnets 32 mounted on the periphery of a rotatable disc 30. When the disc 30 is coupled to a rotating device, the disc 30 and pulser 10 provide a set of output pulses which measure the rotational speed of the device. As each magnet 32 passes over the top of the cap 20, it is magnetically coupled to the Wiegand wire 22 thereby causing the Wiegand wire 22 to switch state. This state switch generates an output pulse in the pick-up coil 18.

An hypothesis as to the operation of the Wiegand wire 22 has been described in the referenced patents and those descriptions are incorporated herein. A repetition of that discussion need not be engaged in at this point.

In broad and simple terms, when a strong enough external magnetic field, such as the field provided by a magnet 32, is coupled to a Wiegand wire, the magnet captures the entire Wiegand wire forcing the Wiegand wire into what has been called a set state or confluent state. A state change in the wire occurs when the external field reverses direction. Each change of state of the Wiegand wire occurs very rapidly. Because it occurs very rapidly, the change in the pattern of the magnetic flux adjacent to the Wiegand wire changes very rapidly. This rapid rate of change of flux with time is sensed by the pick-up coil 18 to provide an output pulse.

### Operation of the Fig. 1 Pulser

The magnets 32 pass over the top of the FIG. 1 pulser unit 10 with the axis of each magnet 32 in alignment with the axis of the Wiegand wire 22. The wire 22 switches state and a substantial output pulse is provided (see FIG. 4A). The position and configuration of the guide elements 12 shape and control the magnetic field to which the Wiegand wire 22 is subjected in a fashion which optimizes the operation of the Wiegand wire segment 22. The conical or funnel shaped cavity area 12b conducts the flux from the exciting magnet 32 axially toward the air gap 28 between the elements 12. The ends of the wire 22 are substantially shielded from the external flux. In part, this is due to the fact that the ends of the wire 22 are spaced from the air gap 28 and, perhaps more importantly, because the greater volume of the guide element 12 immediately adjacent to the ends of the wire 22 serves to carry incident flux inboard toward the air gap 28. In this fashion, a substantially zero magnitude field at the ends of the Wiegand wire serves to substantially reduce or eliminate the demagnetization end effects which have been observed in connection with the switching of a Wiegand wire. The result is a larger output pulse from the module 10 than is achieved where these demagnetization end effects exist. This end effect phenomenon has been observed, although it is not entirely understood as to why it occurs. U.S. Patent No. 4,484,090 is directed to a prior art technique of minimizing these end effects in a pulser. However, what has been found is that a much more consistent and somewhat greater output pulse can be obtained with the device of this invention. Part of the reason is believed to be that the guide elements 12 serve to shield the ends of the wire from all stray magnetic effects.

The guide elements 12 are a soft ferro-magnetic material. In one embodiment, they are a powdered iron of magnetic grade and provide a low reluctance path for the magnetic field generated by the magnet 32. The cap 20, being of stainless steel material, is transparent to the magnetic flux and thus has no effect on the magnetic operation of this pulse generator unit 10.

The pulser unit 10 of FIG. 1 may be actuated by a rotating disk 30, as shown in FIG. 4. The disk 30 has a series of magnets 32 of alternating polarity, as shown. A first one of the magnets 32 will magnetize the Wiegand wire 22 in a first direction and in doing so will provide a first output pulse. As the first magnet rotates away from the pulser unit, a second magnet 32 having opposite polarity will drive the Wiegand wire into an opposing magnetic polarity and will generate a second pulse. The pulses generated by alternate magnets in the FIG. 4 embodiment will be of opposite polarity. A waveform of the output pulse train from the FIG. 4 arrangement is shown in FIG. 4A.

What has been observed about the FIG. 1 design is that it is very forgiving of alignment and spacing variations between the actuating magnet 32 and the pulser unit 10. Thus, if the axis of the exciting magnet 32 is not parallel to the axis of the Wiegand wire 22, the pulser 10 will operate to provide the output pulse. Similarly, if the spacing between the magnet 32 and the pulser unit 10 varies, the desired output pulse will be obtained. The guide elements 12 serve to collect, conduct, and guide the incident flux from the magnet 32 in such as fashion as to concentrate this flux across the gap 28 in a direction that is parallel to the axis of the Wiegand wire 22. This concentration of flux saturates the air gap between the elements 12 thereby creating enough leakage flux to subject the Wiegand wire 22 to an optimal excitation field.

In brief, the guide elements 12 provide both a magnetic shielding function for the ends of the Wiegand wire and a magnetic flux ducting function to facilitate switching.

In one specific embodiment of this invention which has been constructed and tested, a glass tube 24 approximately 1.1 cm long contains a Wiegand wire segment 22 that is approximately 1 cm in length. Wire 22 has a diameter of approximately one-quarter millimeter and it is slipped into the tube 24 which has an outer diameter of approximately 1 mm and an inner diameter of approximately 0.38 mm. The wire need not be fastened inside the tube because the two end-caps 26 prevent the wire from falling out. The coil 18 has 2,000 turns of No. 44 magnet wire and it is positioned on the center 7 mm of the tube 24. Approximately 2 mm of each end of the tube 24 is contained in the cap portion of the rubber end-cap 26. Each element 12 is made out of magnetic grade powdered iron and has an overall length of approximately 6.3 mm and square sides of approximately 6.3 mm. The axial length of the two cavities 12a and 12b is approximately 5 mm and the axial length of the cavity 12b is approximately 2.8 mm. The gap 28 between the two faces 12f is approximately 2.54 mm.

### The Hysteresis Curves

The application of a drive field to only the center portion of a Wiegand wire segment is called herein the short drive field to contrast it with the long field arrangement which has been used in the past for Wiegand wire switching. In a long field arrangement, the drive field may be created by a solenoid with the Wiegand wire positioned in the center of the solenoid and the ends of the wire well within the solenoid. That long solenoid drive field is analogous to the excitation of the Wiegand wire by a magnet passing the wire where the field of the magnet affects the ends of the wire.

By contrast, the two elements 12 provide a short field in that only the center of the wire 22 is subject to the drive field.

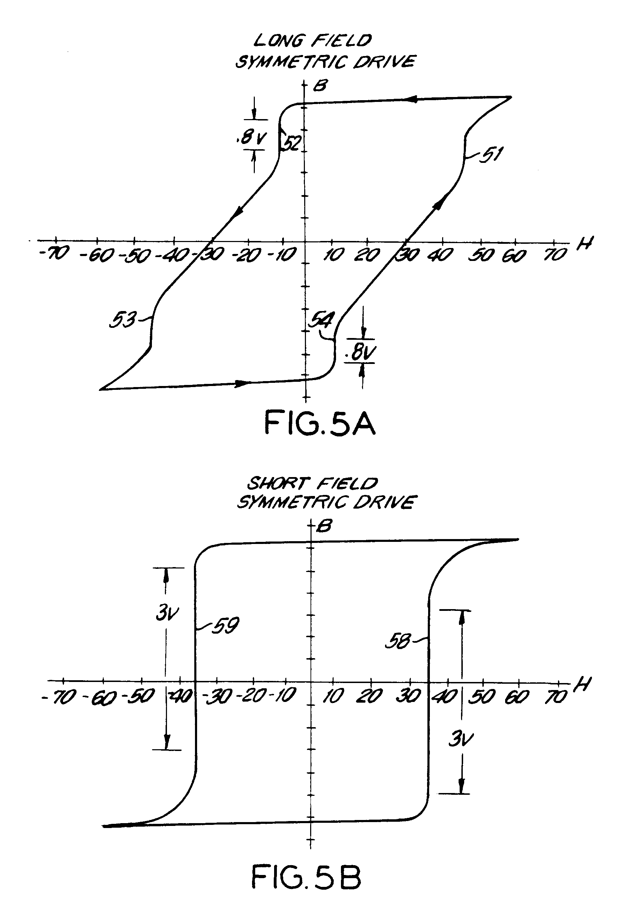

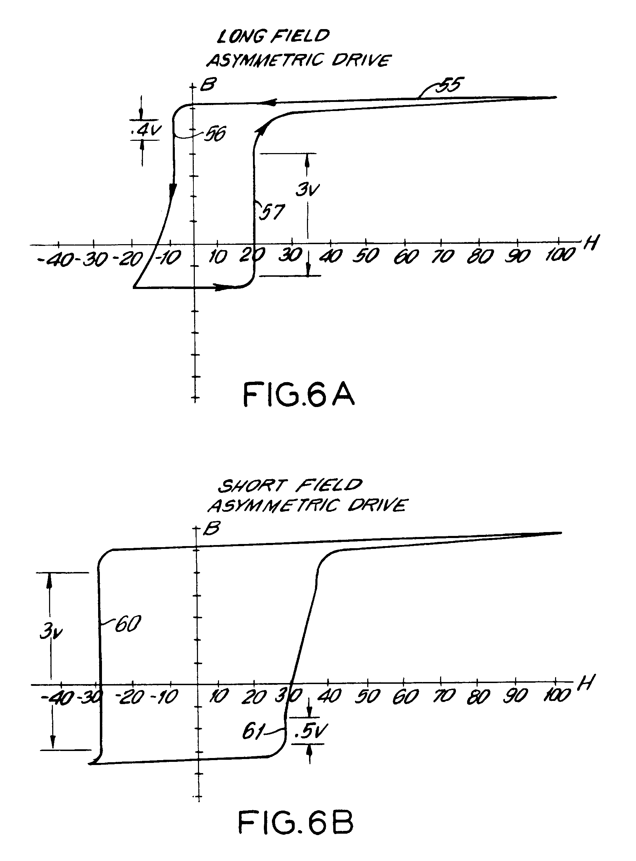

FIGS. 5A, 5B, 6A and 6B contrast the hysteresis curves obtained by exciting the Wiegand wire in a long field and in a short field, in symmetric drive and in asymmetric drive. The drive refers to the field imposed on the Wiegand wire by an external source such as a solenoid or a magnet. It should be noted that the long drive field arrangement which has been extensively employed, provides a switching model that does not adequately explain the results of the short drive field. As described in the referenced patents, and in other patents, the switching state of the Wiegand wire produces a change in the field around the wire which can be sensed by a pick-up coil to provide an output pulse. Because this change of state occurs rapidly, the rate of change of flux with time is significant enough to provide a meaningful output pulse.

In the long symmetric drive field situation, it was noted that as the field went more positive so as to force the core into the same direction of magnetization as the shell a first very small pulse could be detected. That pulse occurs in the region 51 shown in Fig. 5A as the wire switches from a reverse state to a confluent state. When the drive field is reduced, at a small negative field (about 10 Oersteds) the shell is able to recapture the core and the wire switches from its confluent state to a reverse state and a more significant output pulse is provided at the zone 52 on the hysteresis curve of FIG. 5A. Further driving the excitation field negative to about minus 60 Oersteds creates another small output pulse at the zone 53 where the wire switches from reverse state to confluent state. In the confluent state, past zone 53 the direction of magnetization of the core and shell are the same but they are in the reverse direction from the direction when they are in the confluent state past the zone 51. Reduction of the absolute magnitude of the negative field causes the wire to switch state at the zone 54 from confluent state to reverse state when the exciting field goes slightly positive. This produces an output pulse. This model in which the exciting field and the shell field compete with one another to capture the core as the means for explaining these four switching zones 51, 52, 53 and 54 has only limited value in explaining what happens in the other drive situations.

FIG. 6A illustrates what happens under asymmetric drive employing the long drive field. A strong positive drive field forces core and shell into the same magnetization. There is no comparable negative (opposite direction) field applied. The asymmetric drive results in asymmetric pulses. Essentially, after the strong excitation field, at the zone 55 of FIG. 6A, has created a confluent state for the wire, the decrease in the magnitude of the excitation field to a small negative value, as the zone 56, produces the relatively small output pulse similar to that shown in FIG. 5A when the wire switches from its confluent state to its reverse state. By not taking the wire to the point where a negative confluent state is created, an interesting thing occurs that provides a much stronger output pulse. Specifically, by bringing the excitation field in a positive going direction while the wire is still in its reverse state, a much sharper output pulse is obtained at the zone 57 when the wire switches from its reverse state to its positive going confluent state. The result is to provide a much more substantial and thus more usable output pulse. Because of this higher amplitude pulse obtained by the switching at zone 57, the long field asymmetric drive became preferred over the long field symmetric drive and asymmetric drive became the standard drive used in commercial applications.

However, for most applications of a pulser device, it would be preferable to have symmetric drive in which alternate positive and negative going pulses would be provided. Such provides twice the number of pulses per hysteresis cycle.

Accordingly, one of the advantages of this invention involving an effective, repeatable short field drive is that it makes possible the symmetric drive arrangement with the two substantial pulses per cycle, at zones 58 and 59 as shown in FIG. 5B. It is believed that the underlying reason for the substantial pulse developed at 57 in FIG. 6A is the same as the reason for the substantial pulses developed at 58 and 59 in FIG. 5B. However, it is not clear why these substantial pulses are created under these conditions. It is notable that the short field asymmetric drive provides a hysteresis curve as shown at FIG. 6B in which the substantial output pulse occurs at the zone 60. It is not known why the single substantial pulse per cycle provided by asymmetric drive should appear at different places in the long field and short field hysteresis loops.

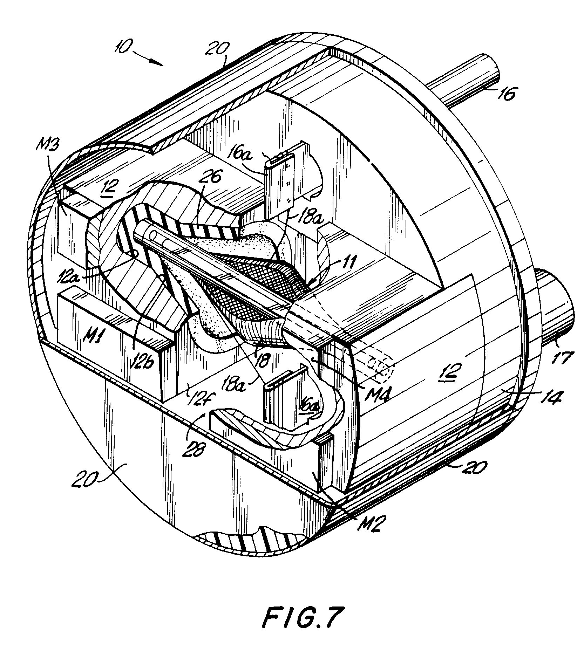

### The Shunt Actuated Embodiments (Figs. 7-12)

These embodiments are similar to the FIG. 1 embodiment except that magnets M1, M2, M3 and M4 are mounted on the guide elements 12a and 12b. Accordingly, the same reference numerals are used in FIGS. 1 and 7 to indicate identical parts.

A first set of magnets M1, M2 are mounted respectively on first and second guide elements 12. The direction of magnetization of these magnets M1 and M2 are opposite to one another. The magnets M1 and M2 constitute the active elements in a first magnetic circuit which is coupled through the two guide elements 12 to the Wiegand wire module 11. A second set of magnets M3 and M4 are mounted respectively on first and second guide elements 12. These magnets M3 and M4 provide the active elements in a second magnetic circuit which is coupled through the two guide elements 12 to the Wiegand wire module 11. The magnetization of M3 and M4 are opposite in direction so that they can provide the appropriate circuit.

The direction of magnetization of the magnets M1 and M3 on the first guide element 12 are in opposite directions from one another and of necessity the same opposite magnetization relationship exists between the magnets M2 and M4 on the second guide element 12. As a result, the directions of the first and second magnetic fields at the Wiegand wire module 11 are opposed to one another. Because the magnets M1, M2, M3 and M4 are of the same strength and the pairs are positioned symmetrically relative to the axis of the module 11, the strength of the two fields at the Wiegand wire module are normally equal to one another. Because they are opposite to one another, they substantially cancel out at the Wiegand wire module. Until the strength of one or the other field is substantially increased by means of shunt 40, discussed hereinafter, the Wiegand wire module 11 is substantially uninfluenced by these fields.

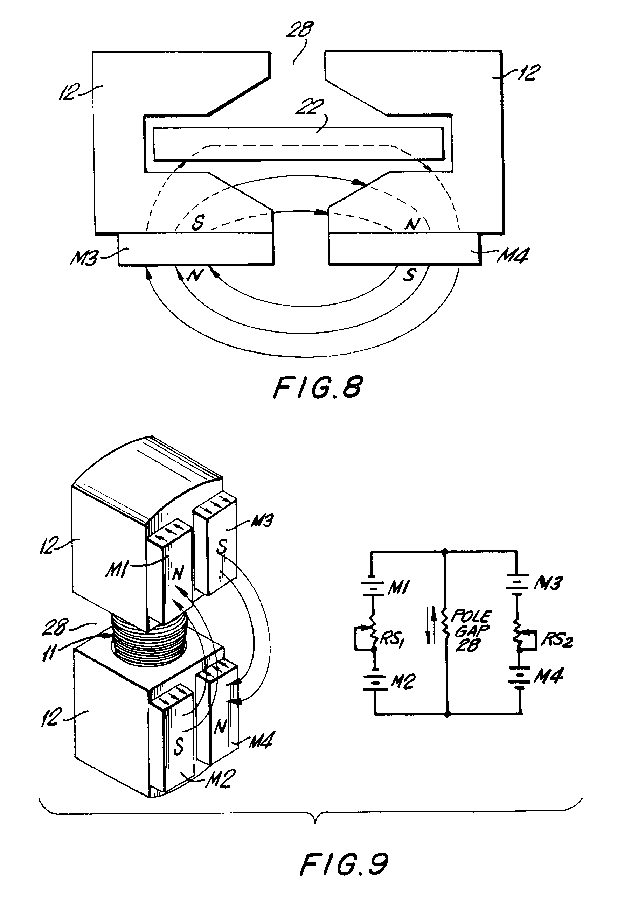

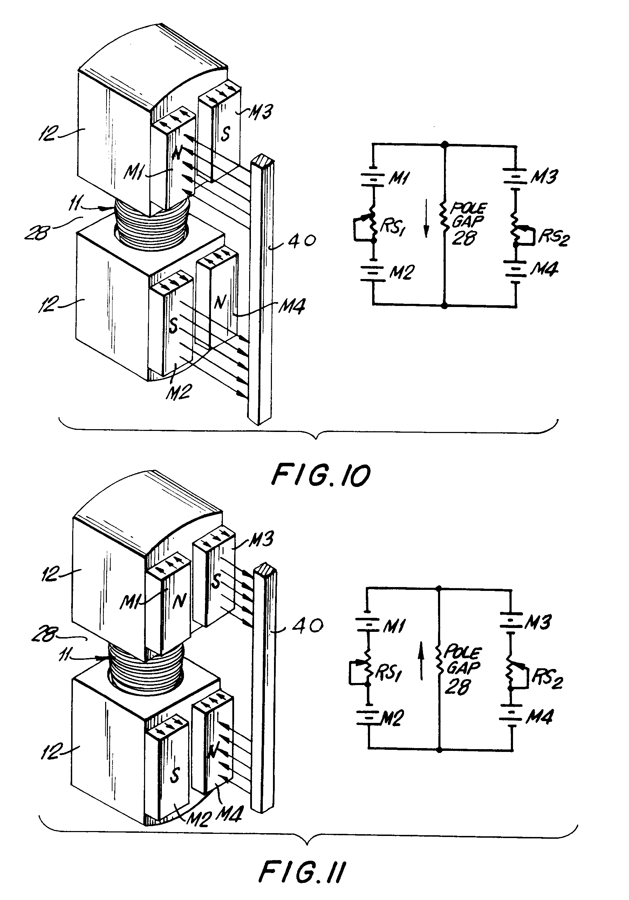

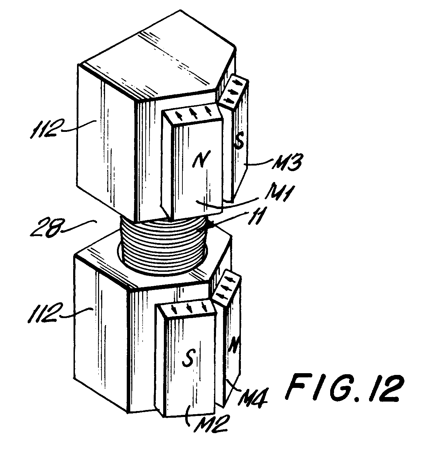

As shown in FIGS. 10 and 11, the pulser is actuated by the position of a ferro-magnetic shunt element 40. The shunt element 40 has a removed position in which case the pulser has what might be called the open circuit state shown in FIG. 9. In that state, the first magnetic circuit which incorporates the magnets M1 and M2 includes the external air gap RS1 and the pole gap 28. Because of the polarity of the four magnets relative to one another, the flux generated by the first and second magnetic circuits is substantially equal in magnitude and opposite in direction across the pole gap 28. Accordingly, the net leakage flux coupled to the Wiegand wire element 22 is nil.

However, as shown in FIG. 10, when the shunt 40 is brought into its first proximate position adjacent to the magnets M1 and M2 it provides a low reluctance external path for the magnetic field generated by the magnets M1 and M2. This decrease in the reluctance RS1 substantially increases the total flux in the first circuit thereby causing the flux across the air gap 28 to overwhelm the countervailing flux in the second circuit. The result is that the leakage flux across the air gap 28 is primarily due to the flux having the direction of the arrow shown in the equivalent circuit in FIG. 10. This leakage flux is thereby coupled to the Wiegand wire element 22 causing the Wiegand wire to switch into a first state at a rapid rate thereby generating a pulse having a first polarity in the pick-up coil 18.

Similarly, as shown in FIG. 11, when the shunt 40 is brought into its first proximate position adjacent to the magnets M3 and M4 it provides a low reluctance external path for the magnetic field generated by those magnets. This decrease in the reluctance RS2 substantially increases the total flux in the second circuit causing flux across the air gap 28 to overwhelm the countervailing flux in the first circuit. The result is that the leakage flux across the air gap 28 is primarily due to the flux having the direction of the arrow shown in the equivalent circuit in FIG. 11. This leakage flux is coupled to the Wiegand wire element 22 causing the Wiegand wire to switch into a second state at a rapid rate thereby generating a pulse having a second polarity in the pick-up coil 18.

The pulses generated by the alternate positions of the shunt 40 shown in FIGS. 10 and 11 will be of opposite polarity. A waveform of the output pulse train is the same as is shown in FIG. 4.

In operation, a shunt element is alternatively brought adjacent to the magnets M1/M2 of the first circuit and the magnets M3/M4 of the second circuit to cause a switch of state that provides the pulse train of FIG. 4. The shunt that triggers these pulses need not be a single shunt element. A typically shunt trigger could be a rotating disk having a series of lobes or projections of low reluctance material in which each projection first triggers a positive pulse and then a negative pulse.

Although an exact and complete theory for the operation of this invention has not presently been developed, the switching mode is one that has been called short field symmetric drive mode and is described in connection with FIG. 5B.

## Claims

1. Device for the generation of an electric pulse in response to a changing magnetic field, comprising
a pulser unit (10) having a Wiegand wire module (11) and soft ferro-magnetic guide means (12),
said Wiegand wire module (11) including a Wiegand wire segment (22) and a pick-up coil (18) wound on said segment (22), said module having first and second end portions,
said ferro-magnetic guide means (12) surrounding at least first and second ends of said module, said guide means (12) including a high reluctance zone adjacent to the center of said module (11) and a lower reluctance zone adjacent to the ends of said module (11),
said guide means (12) being shaped to collect and guide flux that is incident on the pulser unit (10) to said high reluctance zone causing leakage flux to be coupled to the center portion of said Wiegand wire (22),
said guide means (12) including first and second guide elements spaced from one another to provide said high reluctance zone.

2. Device according to claim 1, characterized by
a magnetic unit (30, 32), and
means (30) for moving said pulser unit (10) and magnet unit (30, 32) into and out of proximity with one another.

3. Device according to claim 1, characterized in that the guide elements (12) are spaced from one another to provide an air gap (28).

4. Device according to claim 1, characterized by
first magnet means (M1, M3),
second magnet means (M2, M4),
said first magnet means and said guide means comprising a first magnetic circuit having a first magnetic field coupled to said module (11),
said second magnet means and said guide means providing a second magnetic circuit having a second field coupled to said module (11),
said first and second fields having a normal state in which said fields are substantially opposite in direction and equal in absolute magnitude along the axis of said center portion of said Wiegand wire,
such that the placing of a low reluctance shunt (40) adjacent to one of said magnet means will increase the magnitude of the field in the associated magnetic circuit thereby increasing the flux from that magnetic circuit at said module to cause said Wiegand wire to be actuated by that field.

5. Device according to claim 4, characterized in that
said first magnet means comprises first and second spaced apart magnets, said first magnetic circuit linking a pole of said first magnet having a first polarity to a pole of said second magnet having a second polarity through an external air gap, said first circuit linking a pole of said first magnet having a second polarity to a pole of said second magnet having a first polarity through said guide means,
said second magnet means comprises third and fourth spaced apart magnets, said second magnetic circuit linking a pole of said third magnet having a second polarity to a pole of said fourth magnet having a first polarity through an external air gap, said second circuit linking a pole of said third magnet having a first polarity to a pole of said fourth magnet having a second polarity through said guide means,
said guide means includes first and second guide elements spaced from one another to provide an air gap (28) as said high reluctance zone, leakage flux from said air gap (28) being coupled through said center portion of said Wiegand wire (11).

6. Device according to claim 5, characterized by
a low reluctance shunt (40) movable relative to said first and second magnet means between a first proximate position near to said first magnet means and a second proximate position near to said second magnet means,
said shunt (40) when in said first proximate position providing a low reluctance path for said first field to enhance the magnitude of said first field at said center portion of said Wiegand wire (11) sufficient to cause said Wiegand wire to be actuated by said fist field,
said shunt (40) when in said second proximate position providing a low reluctance path for said second field to enhance the magnitude of said second field at said center portion of said Wiegand wire (11) sufficient to cause said Wiegand wire (11) to be actuated by said second field.

7. Device according to any of claims 3, 5 or 6, characterized in that each of said guide elements (12 ) has a cavity (12a, 12b), the outboard ends of said cavities encompassing said first and second ends of said module.

8. Device according to claim 7, characterized in that
said cavity of each of said guide elements is greater in cross sectional area adjacent said center portion of said module and lesser in cross sectional area adjacent an end portion of said module,
said pick-up coil (18) is wound on a center portion of said wire (11), the ends of said wire extending out of said coil, and
said cavity of each of said guide elements includes a cylindrical recess (12a) for retaining an end of said wire (11).

9. Method of providing a pulse train comprising the steps of:
providing a pulser unit having (a) a Wiegand wire module having a Wiegand wire segment (11) and a pick-up coil (18) wound on said segment, said module having first and second end portions, (b) soft ferro-magnetic guide means encompassing at least first and second ends of said module, said guide means including first and second guide elements spaced from one another to provide a high reluctance zone and being configured to collect, conduct and guide incident flux to said high reluctance zone, flux saturation at said high reluctance zone causing leakage flux to be coupled to said Wiegand wire, (c) first magnet means adjacent to said guide means to provide a first magnetic field coupled to said Wiegand wire through said guide means, and (d) second magnet means adjacent to said guide means to provide a second magnetic field coupled through said guide means to said Wiegand wire, and
alternating placing a ferro-magnetic shunt adjacent to said first and second magnet means to alternately provide low reluctance paths for said first and second magnetic fields and alternately switch said Wiegand wire by said first and second magnetic fields.

10. Method according to claim 9, characterized in that, when said shunt (40) is in a remote position, said first and second magnetic fields at said Wiegand wire are substantially equal in magnitude and opposite in direction.

## Patentansprüche

1. Vorrichtung zum Erzeugen eines elektrischen Impulses nach Maßgabe eines sich ändernden Magnetfeldes mit
einer Impulsbildungseinheit (10) mit einem Wiegand-Drahtmodul (11) und weichen ferromagnetischen Führungsmitteln (12),
wobei der Wiegand-Drahtmodul (11) ein Wiegand-Drahtsegment (22) und eine um dieses gewickelte Aufnahmespule (18) enthalt und das Modul erste und zweite Endabschnitte aufweist,
wobei die ferromagnetischen Führungsmittel (12) mindestens das erste und das zweite Ende des Moduls umschließen, die Führungsmittel (12) am Zentrum des Moduls (11) eine Zone hoher Reluktanz und an den Enden des Moduls (11) eine Zone niedrigerer Reluktanz aufweisen,
die Führungsmittel (12) so geformt sind, daß sie den auf die Pulsbildungseinheit (10) auftreffenden Magnetfluß sammeln und auf die Zone hoher Reluktanz leiten und damit die Kopplung des Streuflusses auf den Mittelabschnitt des Wiegand-Drahtes (22) bewirken,
wobei die Führungsmittel (12) unter Ausbildung dieser Zone mit hoher Reluktanz einen Abstand voneinander aufweisende erste und zweite Führungselemente aufweisen.

2. Vorrichtung nach Anspruch 1, gekennzeichnet durch
eine Magneteinheit (30, 32) und
Mittel (30) zum Verschieben der Impulsbildungseinheit (10) und der Magneteinheit (30, 32) in die und aus der Nachbarschaft miteinander.

3. Vorrichtung nach Anspruch 1, dadurch gekennzeichnet, daß die Führungselemente (12) zur Ausbildung eines Luftspaltes (28) einen Abstand voneinander aufweisen.

4. Vorrichtung nach Anspruch 1, gekennzeichnet durch
ein erstes Magnetmittel (M1, M3),
ein zweites Magnetmittel (M2, M4),
wobei das erste Magnetmittel und die Führungsmittel einen ersten Magnetkreis mit einem an den Modul (11) gekoppelten ersten Magnetfeld aufweisen,
wobei das zweite Magnetmittel und die Führungsmittel einen zweiten Magnetkreis mit einem an den Modul (11) gekoppelten zweiten Feld bilden,
wobei das erste und das zweite Feld einen normalen Zustand aufweisen, in dem die Felder entlang der Achse des Mittelabschnittes des Wiegand-Drahtes in der Richtung im wesentlichen entgegengesetzt und in der absoluten Größe gleich sind,
so daß die Anordnung eines eine niedrige Reluktanz aufweisenden Shunts (40) an einem der Magnetmittel die Größe des Feldes in dem zugehörigen Magnetkreis erhöht und damit der Magnetfluß vom Magnetkreis an diesem Modul ansteigt und eine Betätigung des Wiegand-Drahtes durch dieses Feld bewirkt.

5. Vorrichtung nach Anspruch 4, dadurch gekennzeichnet, daß
das erste Magnetmittel einen ersten und einen zweiten Magneten aufweist, die auseinanderliegen, wobei der erste Magnetkreis einen Pol des ersten Magneten mit einer ersten Polarität mit einem Pol des zweiten Magneten mit einer zweiten Polarität über einen äußeren Luftspalt verbindet und der erste Kreis einen Pol des ersten Magneten mit einer zweiten Polarität mit einem Pol des zweiten Magneten mit einer ersten Polarität über die Führungsmittel verbindet,
das zweite Magnetmittel einen dritten und einen vierten Magneten aufweist, die auseinanderliegen, der zweite Magnetkreis einen Pol des dritten Magneten mit einer zweiten Polarität mit einem Pol des vierten Magneten mit einer ersten Polarität über einen äußeren Luftspalt verbindet und der zweite Magnetkreis einen Pol des dritten Magneten mit einer ersten Polarität mit einem Pol des vierten Magneten mit einer zweiten Polarität über die Führungsmittel verbindet,
die Führungsmittel erste und zweite Führungselemente aufweisen, die unter Bildung eines die Zone der hohen Reluktanz bildenden Luftspaltes (28) in einem Abstand voneinander liegen und der Streufluß vom Luftspalt (28) durch den Mittelabschnitt des Wiegand-Drahtes (11) angekoppelt wird.

6. Vorrichtung nach Anspruch 5, gekennzeichnet durch
einen gegenüber dem ersten und dem zweiten Magnetmittel zwischen einer ersten naheliegenden Stellung nahe an dem ersten Magnetmittel und einer zweiten naheliegenden Stellung nahe dem zweiten Magnetmittel verschiebbaren, eine niedrige Reluktanz aufweisenden Shunt (40),
wobei der Shunt (40), wenn er sich in der ersten naheliegenden Stellung befindet, für das erste Feld eine eine niedrige Reluktanz aufweisende Bahn ausbildet zum Erhöhen der Größe des ersten Feldes am Mittelabschnitt des Wiegand-Drahtes (11), die ausreicht, um eine Betätigung des Wiegand-Drahtes durch das erste Feld zu bewirken, und
wobei der Shunt (40), wenn er sich in der zweiten naheliegenden Stellung befindet, für das zweite Feld eine eine niedrige Reluktanz aufweisende Bahn ausbildet zum Erhöhen der Größe des zweiten Feldes am Mittelabschnitt des Wiegand-Drahtes (11), die ausreicht, um eine Betätigung des Wiegend-Drahtes (11) durch das zweite Feld zu bewirken.

7. Vorrichtung nach irgendeinem der Ansprüche 3, 5 oder 6, dadurch gekennzeichnet, daß jedes Führungselement (12) eine Vertiefung (12a, 12b) aufweist und deren Außenenden das erste und das zweite Ende des Moduls umschließen.

8. Vorrichtung nach Anspruch 7, dadurch gekennzeichnet, daß
die Vertiefung jedes Führungselementes am Mittelabschnitt des Moduls im Querschnitt größer und an einem Endabschnitt des Moduls im Querschnitt kleiner ist,
die Aufnahmespule (18) um einen Mittelabschnitt des Drahtes (11) gewickelt ist und die Enden des Drahtes aus der Spule heraus verlaufen und
die Vertiefung jedes Führungselementes zum Festhalten eines Endes des Drahtes (11) eine zylinderförmige Ausnehmung (12a) enthält.

9. Verfahren zum Ausbilden einer Impulsfolge mit den folgenden Stufen:
Vorsehen einer Impulsbildungseinheit (a) mit einem Wiegand-Drahtmodul mit einem Wiegand-Drahtsegment (11) und einer um das Segment gewickelten Aufnahmespule (18), wobei der Modul einen ersten und einen zweiten Endabschnitt aufweist, (b) mit weichen ferromagnetischen Führungsmitteln, die mindestens das erste und das zweite Ende des Moduls umschließen, wobei die Führungsmittel erste und zweite Führungselemente aufweisen, die zum Ausbilden einer eine hohe Reluktanz aufweisenden Zone in einem Abstand voneinander liegen und so geformt sind, daß sie den auf diese die hohe Reluktanz aufweisende Zone auftreffenden Magnetfluß sammeln, leiten und führen, und die Flußsättigung an der die hohe Reluktanz aufweisenden Zone bewirkt, daß der Streufluß an den Wiegand-Draht gekoppelt wird, (c) mit einem ersten Magnetmittel an dem Führungsmittel zum Ausbilden eines über das Führungsmittel an den Wiegand-Draht gekoppelten ersten Magnetfeldes und (d) mit einem zweiten Magnetmittel am Führungsmittel zum Ausbilden eines durch das Führungsmittel an den Wiegand-Draht angekoppelten zweiten Magnetfeldes und
alternierendes Anordnen eines ferromagnetischen Shunts am ersten und zweiten Magnetmittel zum alternierenden Ausbilden von eine niedrige Reluktanz aufweisenden Pfaden für das erste und das zweite Magnetfeld und zum alternierenden Umschalten des Wiegand-Drahtes durch das erste und das zweite Magnetfeld.

10. Verfahren nach Anspruch 9, dadurch gekennzeichnet, daß sich bei in einer abgelegenen Stellung befindendem Shunt (40) das erste und das zweite Magnetfeld am Wiegand-Draht in der Größe im wesentlichen gleich und in der Richtung entgegengesetzt sind.

## Revendications

1. Dispositif pour la production d'une impulsion électrique en réaction à un champ magnétique qui se modifie, comprenant un générateur d'impulsions (10) comportant un module à fil de Wiegand (11) et des moyens de guidage en matière ferromagnétique douce (12),
le module à fil de Wiegand (11) comprenant un segment de fil de Wiegand (22) et une bobine de captage (18) enroulée sur le segment (22), le module comportant une première et une seconde partie d'extrémité,
les moyens de guidage en matière ferromagnétique (12) entourant au moins la première et la seconde extrémité du module, les moyens de guidage (12) comprenant une zone à haute réluctance adjacente au centre du module (11) et une zone à réluctance moindre adjacente aux extrémités du module (11),
les moyens de guidage (12) étant façonnés de manière à recueillir et à guider le flux qui touche le générateur d'impulsions (10) vers la zone à haute réluctance, provoquant l'application d'un flux de fuite à la partie médiane du fil de Wiegand (22),
les moyens de guidage (12) comprenant un premier et un second élément de guidage espacés l'un de l'autre pour fournir la zone à haute réluctance.

2. Dispositif suivant la revendication 1, caractérisé par
une unité magnétique (30, 32), et
un moyen (30) pour déplacer le générateur d'impulsions (10) et l'unité magnétique (30, 32) en vue de les amener à proximité l'un de l'autre et de les écarter de cette proximité.

3. Dispositif suivant la revendication 1, caractérisé en ce que les éléments de guidage (12) sont espacés l'un de l'autre pour ménager un entrefer (28).

4. Dispositif suivant la revendication 1, caractérisé par
un premier moyen magnétique (M1, M3)
un second moyen magnétique (M2, M4)
le premier moyen magnétique et les moyens de guidage formant un premier circuit magnétique comportant un premier champ magnétique appliqué au module (11),
le second moyen magnétique et les moyens de guidage fournissant un second circuit magnétique comportant un second champ appliqué au module (11),
le premier et le second champ ayant un état normal dans lequel les champs sont en substance opposés en sens et égaux en valeur absolue le long de l'axe de la partie médiane du fil de Wiegand, de sorte que la mise en place d'un shunt à faible réluctance (40) à proximité de l'un des moyens magnétiques accroît la valeur du champ dans le circuit magnétique associé, augmentant ainsi le flux de ce circuit magnétique audit module pour faire en sorte que le fil de Wiegand soit actionné par ce champ.

5. Dispositif suivant la revendication 4, caractérisé en ce que
le premier moyen magnétique comprend un premier et un deuxième aimant espacés, le premier circuit magnétique reliant un pôle du premier aimant d'une première polarité à un pôle du second aimant d'une seconde polarité via un entrefer externe, le premier circuit reliant un pôle du premier aimant d'une seconde polarité à un pôle du second aimant d'une première polarité via les moyens de guidage,
le second moyen magnétique comprend un troisième et un quatrième aimant espacés, le second circuit magnétique reliant un pôle du troisième aimant d'une seconde polarité à un pôle du quatrième aimant d'une première polarité via un entrefer externe, le second circuit reliant un pôle du troisième aimant d'une première polarité à un pôle du quatrième aimant d'une seconde polarité via les moyens de guidage,
les moyens de guidage comprennent un premier et un second élément de guidage espacés l'un de l'autre pour ménager un entrefer (28) en tant que zone à haute réluctance, le flux de fuite provenant de l'entrefer (28) étant appliqué via la partie médiane du fil de Wiegand (11).

6. Dispositif suivant la revendication 5, caractérisé par
un shunt à faible réluctance (40) mobile par rapport au premier et au second moyen magnétique entre une première position de proximité proche du premier moyen magnétique et une seconde position de proximité proche du second moyen magnétique,
le shunt (40), lorsqu'il se trouve dans la première position de proximité, fournissant un trajet à faible réluctance pour le premier champ en vue d'augmenter la valeur du premier champ, au niveau de la partie médiane du fil de Wiegand (11), dans une mesure suffisante pour provoquer l'actionnement du fil de Wiegand par le premier champ,
le shunt (40) lorsqu'il se trouve dans la seconde position de proximité fournissant un trajet à faible réluctance pour le second champ en vue d'augmenter la valeur du second champ au niveau de la partie médiane du fil de Wiegand (11) dans une mesure suffisante pour provoquer l'actionnement du fil de Wiegand (11) par le second champ.

7. Dispositif suivant l'une quelconque des revendications 3, 5 ou 6, caractérisé en ce que chacun des éléments de guidage (12) comporte une cavité (12a, 12b), les extrémités externes des cavités recevant la première et la seconde extrémité du module.

8. Dispositif suivant la revendication 7, caractérisé en ce que
la cavité de chacun des éléments de guidage est plus grande en coupe transversale à proximité de la partie médiane du module et plus petite en coupe transversale à proximité d'une partie d'extrémité du module,
la bobine de captage (18) est enroulée sur une partie médiane du fil (11), les extrémités du fil s'étendant à l'extérieur de la bobine, et
la cavité de chacun des éléments de guidage comprend un évidement cylindrique (12a) destiné à retenir l'extrémité du fil (11).

9. Procédé de production d'un train d'impulsions comprenant les étapes qui consistent à :
prévoir un générateur d'impulsions comportant (a) un module à fil de Wiegand comportant un segment de fil de Wiegand (11) et une bobine de captage (18) enroulée sur ce segment, le module comportant une première et une seconde extrémité, (b) des moyens de guidage en matière ferromagnétique douce entourant au moins la première et la seconde extrémité du module, les moyens de guidage comprenant un premier et un second élément de guidage espacés l'un de l'autre pour fournir une zone à haute réluctance et étant configurés de manière à collecter, conduire et guider le flux incident vers la zone à haute réluctance, la saturation du flux au niveau de la zone à haute réluctance provoquant l'application d'un flux de fuite au fil de Wiegand, (c) un premier moyen magnétique adjacent aux moyens de guidage pour fournir un premier champ magnétique appliqué au fil de Wiegand via les moyens de guidage, et (d) un second moyen magnétique adjacent aux moyens de guidage pour fournir un second champ magnétique appliqué via les moyens de guidage au fil de Wiegand, et
à placer un shunt ferromagnétique en alternance à proximité du premier et du second moyen magnétique pour alternativement fournir des trajets à faible réluctance pour le premier et le second champ magnétique et alternativement commuter le fil de Wiegand au moyen du premier et du second champ magnétique.

10. Procédé suivant la revendication 9, caractérisé en ce que, lorsqu'un shunt (40) se trouve dans une position située à distance, le premier et le second champ magnétique au niveau du fil de Wiegand sont en substance égaux en valeur et opposés en sens.
